# EUROPEAN PATENT APPLICATION

(11) **EP 1 785 843 A2**
(43) Date of publication of application: **16.05.2007**
(21) Application number: 06000355.5
(22) Date of filing: 10.01.2006
(51) Int. Cl.: G06F 9/24

(54) **Access method and access circuit for flash memory in embedded system**

(30) Priority: 10.11.2005 CN 200510115879
(71) Applicant: Cheertek Inc., Hsinchu 300 (TW)
(72) Inventor: Hsu, Chin-Fu, Hsinchu 300 (TW)
(74) Representative: Helms, Joachim

(57) **Abstract**

The present invention relates an access method for flash memory in an embedded system, including the following steps: divide the flash memory into a main program zone and a storage zone; provide an access circuit having a command register for receiving commands and a microcontroller status buffer; the access circuit detects if the microcontroller executes the command to access the storage zone and, if not, continues to detect; when the microcontroller executes the command to access the storage zone, the access circuit stores the command in the command register for receiving commands, stores the status of the microcontroller in the microcontroller status buffer, and executes the read/write command for the storage zone; the access circuit stores the results of the read/write commands in the command register for receiving commands; and the access circuit retrieves the status of the microcontroller from the microcontroller status buffer to return the microcontroller to its original status to continuously execute access commands. In addition, the present discloses an access circuit which can be used by a microcontroller of an embedded system to read/write external flash memory.

## Description

### Field of The Invention

The present invention relates to an access method and access circuit for flash memory in an embedded system, and in particular, to an access method and access circuit for flash memory in an embedded system which the can return the microcontroller to its original status to continuously execute access commands after accessing external flash memory.

### BACKGROUND OF THE INVENTION

In general, a microcontroller is integrated with an embedded system. For example, in the controller of a LCD TV, DVD player/recorder, or, digital set-top-box, the program code of the microcontroller is usually stored in an external flash memory. However, the flash memory in writing status cannot return to original program status. Namely, after the microcontroller finishes executing a read/write command for the flash memory, the microcontroller has to be rebooted to re-run the program code. The execution time of the microcontroller is therefore wasted. When a large block of continuous memory addresses is being written, the situation is even worse.

Furthermore, the controller of a LVD TV generally needs a non-volatile memory, for example but not limited to electrically erasable programmable read-only memory (EEPROM), to store global variables, adjustable variables of hue and saturation, and image frames. The inclusion of such a non-volatile memory results in an increase in production cost.

To resolve the shortcomings of the embedded system of conventional controller of a LCD TV and others, an access method and access circuit for flash memory in an embedded system is needed to return the microcontroller to its original status to continuously execute access commands after accessing external flash memory. Furthermore, an access method and access circuit for flash memory in an embedded system is needed to store global variables, adjustable variables of hue and saturation, and image frames in flash memory which can be randomly accessed by the controller to cut the cost of installing electrically erasable programmable read-only memory (EEPROM).

### SUMMARY OF THE INVENTION

To solve the shortcoming of the prior art described above, it is an object of the present invention to provide an access method and access circuit for flash memory in an embedded system which can return the microcontroller to its original status to continuously execute access commands after accessing external flash memory.

To solve the shortcoming of the prior art described above, it is another object of the present invention to provide an access method and access circuit for flash memory in embedded systems which can store global variables, adjustable variables of hue and saturation, and image frames in flash memory which can be randomly accessed by the controller in usually operations.

In order to accomplish the objects of the present invention described above, the present invention provides an access method for flash memory in an embedded system, wherein the embedded system has a microcontroller. The method can provide the microcontroller a mean to read/write external flash memory, including the following steps: divide the flash memory into a main program zone and a storage zone; provide an access circuit having a command register for receiving commands and a microcontroller status buffer; the access circuit detects if the microcontroller executes the command to access the storage zone and, if not, continues to detect; when the microcontroller executes the command to access the storage zone, the access circuit stores the command in the command register for receiving commands, stores the status of the microcontroller in the microcontroller status buffer, and executes the read/write command for the storage zone; the access circuit stores the results of the read/write commands in the command register for receiving commands; and the access circuit retrieves the status of the microcontroller from the microcontroller status buffer to return the microcontroller to its original status to continuously execute access commands.

In order to accomplish the objects of the present invention described above, the present invention provides an access circuit which can be used by a microcontroller of an embedded system to read/write external flash memory. The access circuit includes at least: a command register for receiving commands and a microcontroller status buffer. When the access circuit detects that the microcontroller is executing a read/write command for the flash memory, the access circuit stores the command in the command register for receiving commands, stores the status of the microcontroller in the microcontroller status buffer, and executes the read/write command for the flash memory. After the execution is finished, the access circuit stores the results of the read/write command in the command register for receiving commands. Finally, the access circuit sends the status of the microcontroller back to the microcontroller status buffer to return the microcontroller to its original status to continuously execute access commands.

### BRIEF DESCRIPTION OF THE DRAWINGS

The present invention can be more fully understood by reference to the following description and accompanying drawings, in which:

Fig. 1 is a flow chart of a preferred embodiment of an access method for flash memory in an embedded system according to the present invention; and

Figs. 2 is a block diagram of a preferred embodiment of an access circuit according to the present invention.

### DETAILED DESCRIPTION OF THE INVENTION

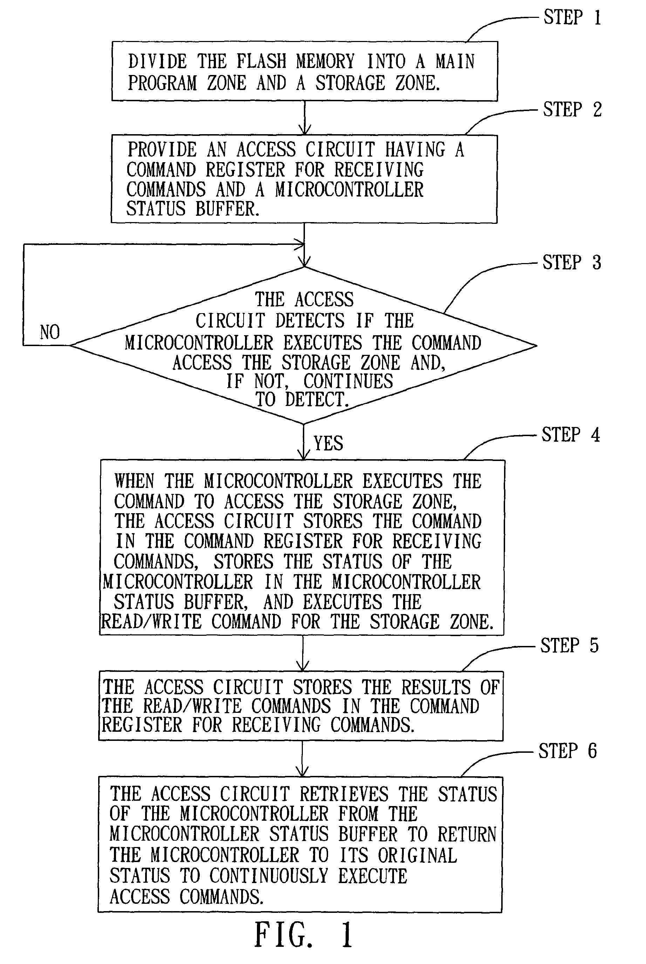

FIG 1 illustrates a flow chart of a preferred embodiment of an access method for flash memory in an embedded system according to the present invention. FIG 1 illustrates an access method for flash memory in an embedded system according to the present invention, wherein the embedded system has a microcontroller. The method can provide the microcontroller a mean to read/write external flash memory, including the following steps: divide the flash memory into a main program zone and a storage zone (step 1); provide an access circuit having a command register for receiving commands and a microcontroller status buffer (step 2); the access circuit detects if the microcontroller executes the command to access the storage zone and, if not, continues to detect (step 3); when the microcontroller executes the command to access the storage zone, the access circuit stores the command in the command register for receiving commands, stores the status of the microcontroller in the microcontroller status buffer, and executes the read/write command for the storage zone (step 4); the access circuit stores the results of the read/write commands in the command register for receiving commands (step 5); and the access circuit retrieves the status of the microcontroller from the microcontroller status buffer to return the microcontroller to its original status to continuously execute access commands (step 6).

In step 1, the flash memory is divided into a main program zone and a storage zone, wherein the main program zone can be used to store the program code of the microcontroller and the storage zone can be used to store global variables, adjustable variables of hue and saturation, and image frames. In this way, the cost of installing electrically erasable programmable read-only memory (EEPROM) commonly used in prior art can be cut. Wherein, the size of the storage zone is larger than that of the main program zone.

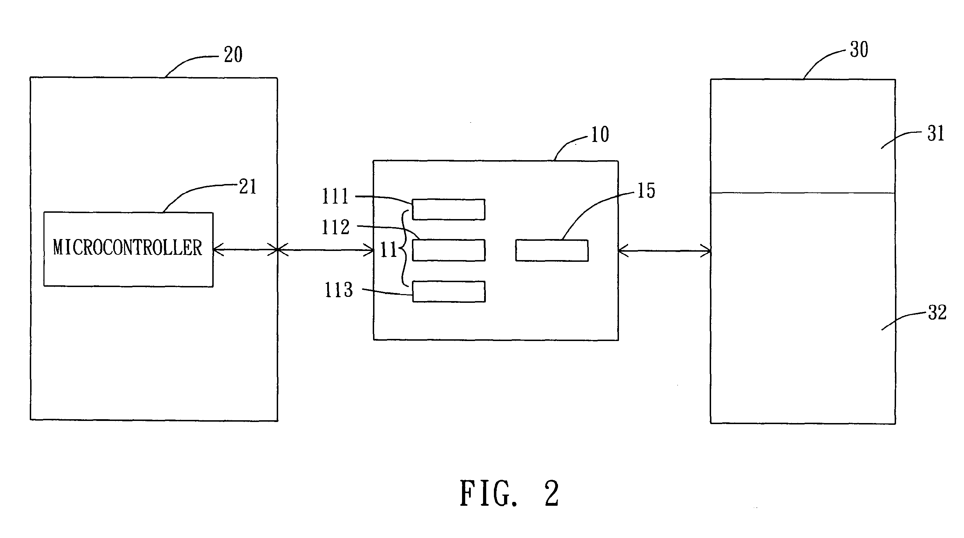

In step 2, an access circuit (details is described in the description for FIG. 2) having a command register for receiving commands and a microcontroller status buffer is provided, wherein the command register for receiving commands further comprises a read/write command register, a read/write data register, and a read/write address register. The length of the read/write command register is one byte for temporarily storing the read/write command. The length of the read/write data register is one byte for temporarily storing the read/write data. The length of the read/write address register is four bytes for temporarily storing the read/write address to render the access circuit have an addressing space of 4G bytes.

In step 3, the access circuit detects if the microcontroller executes the command to access the storage zone and, if not, the microcontroller does not request to access the flash memory. In the mean time, the microcontroller continues to detect the commands from the microcontroller.

In step 4, when the microcontroller executes the command to access the storage zone, the access circuit stores the command in the command register for receiving commands. For example, the read/write command is stored in the read/write command register, the read/write data is stored the read/write data register, and the read/write address is stored in the read/write address register. In this way, the access circuit can write data into the flash memory or read data from the flash memory according to the read/write command. Furthermore, in the step, the status of the microcontroller is further stored in the microcontroller status buffer; the action is similar to that when the microcontroller processes an interrupt procedure, the status is stored in stack. The aim is to remember the location for returning after the microcontroller has finished the read/write command. The microcontroller can return to the location to continuously execute the original program, which is another difference between the present invent and the prior arts.

In step 5, the access circuit stores the results of the read/write commands in the command register for receiving commands. The aim is for the microcontroller to check if the read/write command has been successful. If not, the microcontroller may re-run the read/write command.

In step 6, the access circuit retrieves the status of the microcontroller from the microcontroller status buffer to return the microcontroller to its original status to continuously execute access commands. The aim is for the microcontroller to acquire the address of the next read/write command and the original status of the microcontroller to continuously execute the original program.

Consequently, with aforementioned access method for flash memory in an embedded system which can return the microcontroller to its original status to continuously execute access commands after accessing external flash memory. Furthermore, global variables, adjustable variables of hue and saturation, and image frames can be stored in the flash memory which can be randomly accessed by the controller in normal operations. It is appreciated that the access method for flash memory in an embedded system is indeed different from and better than conventional access methods for flash memory in an embedded system.

FIG. 2 illustrates a block diagram of a preferred embodiment of an access circuit 10 according to the present invention. Referring to FIG. 2, the access circuit 10 according to the present invention can provide a microcontroller 21 in an embedded system 20 to read/write a flash memory 30. The access circuit 10 includes at least: a command register 11 and a microcontroller status buffer 12.

Wherein, the embedded system 20 may be the controller of a LCD TV, DVD player/recorder, or digital set-top-box. The flash memory 30 may further be divided a main program zone 31 and a storage zone 32, wherein the main program zone 31 can be used to store the program code of the microcontroller 21 and the storage zone 32 can be used to store global variables, adjustable variables of hue and saturation, and image frames of the embedded system 20.

The command register 11 further comprises a read/write command register 111, a read/write data register 112, and a read/write address register 113. The length of the read/write command register 111 is one byte for temporarily storing the read/write command. The length of the read/write data register 112 is one byte for temporarily storing the read/write data. The length of the read/write address register 113 is four bytes for temporarily storing the read/write address to render the access circuit 10 have an addressing space of 4G bytes.

Referring to FIGS. 1 and 2, when the access method for flash memory in an embedded system according to the present invention starts to operate, the microcontroller 21 executes the program. When the access circuit 10 detects the microcontroller 21 is executing a read/write command for the storage zone 32, the access circuit 10 stores the command in the command register 11, stores the status of the microcontroller 21 in the microcontroller status buffer 15, and executes the read/write command for the storage zone 32. After the execution of the read/write command is finished, the access circuit 10 stores the read/write command in the command register 11. Finally, the access circuit 10 retrieves the status of the microcontroller 21 from the microcontroller status buffer 15 to return the microcontroller 21 to its original status to continuously execute access commands.

Wherein, the status of the microcontroller 21 is further stored in the microcontroller status buffer 15; the action is similar to that when the microcontroller 21 processes an interrupt procedure, the status is stored in stack. The aim is to remember the location for returning after the microcontroller 21 has finished the read/write command. The microcontroller 21 can return to the location to continuously execute the original program.

When the access circuit 10 detects that the microcontroller 21 is executing a read/write command for the flash memory 30, the access circuit 10 stores the command in the command register 11, stores the status of the microcontroller 21 in the microcontroller status buffer 15, and executes the read/write command for the flash memory 30. After the execution of read/write command is finished, the access circuit 10 stores the read/write command in the command register 11. Finally, the access circuit 10 sends the status of the microcontroller 21 back to the microcontroller status buffer 15 to return the microcontroller 21 to its original status to continuously execute access commands.

An access method and access circuit for flash memory in an embedded system according to the present invention can return the microcontroller to its original status to continuously execute access commands after accessing external flash memory. Furthermore, global variables, adjustable variables of hue and saturation, and image frames can be stored in the flash memory which can be randomly accessed by the controller in usually operations. It is appreciated that the access method and access circuit for flash memory in an embedded system according to the present invention can improve the shortcomings of prior-art access method and access circuit for flash memory in an embedded system.

While the invention has been described with reference to the a preferred embodiment thereof, it is to be understood that modifications or variations may be easily made without departing from the spirit of this invention, which is defined by the appended claims.

## Claims

1. An access method for flash memory in an embedded system, wherein the embedded system has a microcontroller, and the method can provide the microcontroller a mean to read/write external flash memory, including the following steps:
divide the flash memory into a main program zone and a storage zone;
provide an access circuit having a command register for receiving commands and a microcontroller status buffer;
the access circuit detects if the microcontroller executes the command to access the storage zone and, if not, continues to detect;
when the microcontroller executes the command to access the storage zone, the access circuit stores the command in the command register for receiving commands, stores the status of the microcontroller in the microcontroller status buffer, and executes the read/write command for the storage zone;
the access circuit stores the results of the read/write commands in the command register for receiving commands; and
the access circuit retrieves the status of the microcontroller from the microcontroller status buffer to return the microcontroller to its original status to continuously execute access commands.

2. The access method for flash memory in an embedded system as defined in claim 1, wherein the command register for receiving commands further comprises a read/write command register, a read/write data register, and a read/write address register.

3. The access method for flash memory in an embedded system as defined in claim 2, wherein the length of the read/write command register is one byte for temporarily storing the read/write command.

4. The access method for flash memory in an embedded system as defined in claim 2, wherein the length of the read/write data register is one byte for temporarily storing the read/write data.

5. The access method for flash memory in an embedded system as defined in claim 2, wherein the length of the read/write address register is four bytes for temporarily storing the read/write address to render the access circuit have an addressing space of 4G bytes.

6. The access method for flash memory in an embedded system as defined in claim 1, wherein the main program zone can be used to store the program code of the microcontroller and the storage zone can be used to store global variables, adjustable variables of hue and saturation, and image frames of the embedded system.

7. The access method for flash memory in an embedded system as defined in claim 1, wherein the embedded system may be the controller of a LCD TV, DVD player/recorder, or digital set-top-box.

8. An access circuit which can be used by a microcontroller of an embedded system to read/write external flash memory includes at least:
a command register for receiving commands; and
a microcontroller status buffer;
when the access circuit detects that the microcontroller is executing a read/write command for the flash memory, the access circuit stores the command in the command register for receiving commands, stores the status of the microcontroller in the microcontroller status buffer, and executes the read/write command for the flash memory. After the execution is finished, the access circuit stores the results of the read/write command in the command register for receiving commands. Finally, the access circuit sends the status of the microcontroller back to the microcontroller status buffer to return the microcontroller to its original status to continuously execute access commands.

9. The access circuit as defined in claim 8, wherein the command register for receiving commands further comprises a read/write command register, a read/write data register, and a read/write address register.

10. The access circuit as defined in claim 9, wherein the length of the read/write command register is one byte for temporarily storing the read/write command.

11. The access circuit as defined in claim 9, wherein the length of the read/write data register is one byte for temporarily storing the read/write data.

12. The access circuit as defined in claim 9, wherein the length of the read/write address register is four bytes for temporarily storing the read/write address to render the access circuit have an addressing space of 4G bytes.

13. The access circuit as defined in claim 8, wherein the flash memory may further be divided a main program zone and a storage zone, and the main program zone can be used to store the program code of the microcontroller and the storage zone can be used to store global variables, adjustable variables of hue and saturation, and image frames of the embedded system.

14. The access circuit as defined in claim 8, wherein the embedded system may be the controller of a LCD TV, DVD player/recorder, or digital set-top-box.
